# EUROPEAN PATENT APPLICATION

(11) **EP 2 784 936 A1**
(43) Date of publication of application: **01.10.2014**
(21) Application number: 12861717.2
(22) Date of filing: 15.03.2012
(51) Int. Cl.: H03F 3/20

(54) **CIRCULATOR POWER AMPLIFIER CIRCUIT AND DESIGN METHOD THEREFOR**

(30) Priority: 30.12.2011 CN 201110453734
(71) Applicant: ZTE Corporation, Shenzhen, Guangdong 518057 (CN)
(72) Inventor: CHEN, Huazhang, Shenzhen Guangdong 518057 (CN); WANG, Xin, Shenzhen Guangdong 518057 (CN)
(74) Representative: Jones, Cerian
(86) International application number: PCT/CN2012/072368
(87) International publication number: WO 2013/097353

(57) **Abstract**

The present invention provides a circulator power amplifier circuit and a connection method thereof. Wherein, the circulator power amplifier circuit includes a power amplifier, a circulator, a power load and a load. An output end of the power amplifier is connected to an input end of the circulator, the load is connected to an output end of the circulator and the power load is connected to the load end of the circulator, wherein, the circulator is an N-stage circulator or an M-port circulator, where both N and M are integers greater than one. The above circulator power amplifier circuit connected through using the circulator power amplifier circuit connection method increases the isolation for the circulator, and it is of great significance in terms of improving a standing wave of the power amplifier, ensuring stability of specification, preventing mismatch damages of the power amplifier and increasing reliability of the power amplifier.

## Description

### Technical Field

The present invention relates to the field of communications, and in particular, to a circulator power amplifier circuit and a design method thereof.

### Background of the Related Art

In the face of the increasingly fierce market competition, performance of the base station product is the main focus of the industry competition, and as an important component of the base station, the power amplifier unit is directly related to the quality and communication effect of the transmitted signals.

With the change of the power amplifier field to trends such as high efficiency, high linearity, high peak-to-average ratio and high broadband and so on, reliability requirements of the power amplifier is stricter. In the design of the power amplifier, a circulator is generally applied between an output end of the power amplifier and the load (an antenna, a duplexer etc.), to implement unidirectional transmission of signals. The circulator is used in the output end for power amplification in the circuit, protecting a final-stage large power amplifier tube, which plays a role in improving a standing wave of the power amplifier, increasing reverse isolation, avoiding mismatch damages of the power amplifier, and it is an indispensable important part in the reliability design of the whole power amplifier.

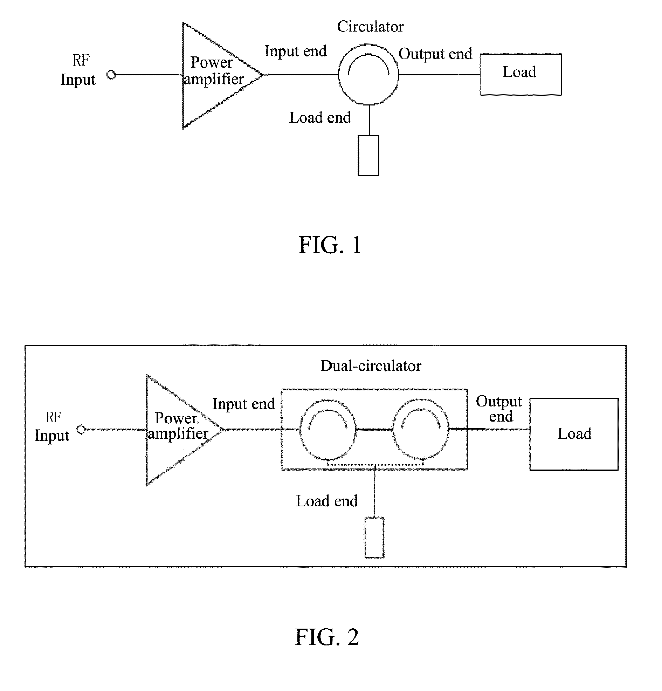

A design of an output of the power amplifier being connected to a single-circulator is common in the field of power amplifier. Generally, for the single-circulator, the isolation is about 23dB, and the standing wave is less than -20dB. As shown in Fig. 1, an input end is connected to the output end of the power amplifier, and the output end is connected to a load (an antenna, a duplexer etc.), and the load end is connected to a power load with 50Ohm. A signal enters into the input end, and exits from the output end, and the output end is matched with 50Ohm, which plays a role in improving the standing wave. A reflected signal is transmitted from the output end to the load end and is absorbed by the power load with 50Ohm, which plays a role in preventing mismatch damages of the power amplifier.

At present, the isolation of the single-circulator is generally about 23dB, and the highest nominal value is only 28dB. However, in the actual application, the isolation often does not reach to the nominal indicator. When the standing wave of the load of the power amplifier is good and stable, the isolation effect of the single-circulator can satisfy the requirements. However, when the load connected to the power amplifier is sensitive and the standing wave is poor, the isolation ability of the single-circulator appears to be insufficient, and the power reflected from the output end to the input end will severely influence the specification of the power amplifier, and even the power amplifier is burnt down.

### Summary of the Invention

The embodiments of the present invention provide a circulator power amplifier circuit and a design method thereof, to solve the problem that the isolation ability of the existing single-circulator is insufficient.

In order to solve the above technical problem, the present invention uses the following technical solutions.

A circulator power amplifier circuit, comprising a power amplifier, a circulator, a power load and a load, an output end of the power amplifier connected to an input end of the circulator, the load connected to an output end of the circulator, and the power load is connected to the load end of the circulator, wherein,
the circulator is an N-stage circulator or an M-port circulator, where both N and M are integers greater than one.

Wherein, when the circulator is an N-stage circulator, an input end of a first-stage circulator is connected to the power amplifier, an output end of an N^{th}-stage circulator is connected to the load, an output end of an i^{th}-stage circulator is connected to an input end of an i+1^{th}-stage circulator, and after load ends of the first-stage circulator to the N^{th}-stage circulator are connected, the load ends are connected to the power load, wherein, i+1 is an integer greater than 1 and less than or equal to N.

Wherein, when the circulator is an N-stage circulator, an input end of a first-stage circulator is connected to the power amplifier, an output end of an N^{th}-stage circulator is connected to the load, an output end of an i^{th}-stage circulator is connected to an input end of an i+1^{th}-stage circulator, and load ends of the first-stage circulator to the N^{th}-stage circulator are respectively connected to respective power loads, wherein, i+1 is an integer greater than 1 and less than or equal to N.

Wherein, an insertion loss value of the N-stage circulator is within 0.4-0.6dB.

Wherein, the M-port circulator is a dual-port circulator.

Wherein, an insertion loss value of the M-port circulator is within 0.2-0.3dB.

A connection method for a circulator power amplifier circuit, comprising:
connecting an output end of a power amplifier to an input end of a multi-circulator, connecting an output end of the multi-circulator to a load, and connecting a load end of the multi-circulator to a power load,
wherein, the multi-circulator is an N-stage circulator or an M-port circulator, wherein, both N and M are integers greater than one.

Wherein, when the circulator is an N-stage circulator, the step of connecting an output end of a power amplifier to an input end of the multi-circulator, connecting an output end of the multi-circulator to a load and connecting the load end of the multi-circulator to a power load comprises:
connecting the output end of the power amplifier to an input end of a first-stage circulator;
connecting an output end of the N^{th}-stage circulator to the load;
connecting an output end of an i^{th}-stage circulator to an input end of an i+1^{th}-stage circulator, wherein, i+1 is an integer greater than 1 and less than or equal to N; and
after load ends of the first-stage circulator to the N^{th}-stage circulator are connected, connecting the load ends to the power load.

Wherein, when the circulator is an N-stage circulator, the step of connecting an output end of a power amplifier to an input end of the multi-circulator, connecting an output end of the multi-circulator to a load and connecting the load end of the multi-circulator to a power load comprises:
connecting the output end of the power amplifier to an input end of a first-stage circulator;
connecting an output end of an N^{th}-stage circulator to the load;
connecting an output end of an i^{th}-stage circulator to an input end of an i+1^{th}-stage circulator, wherein, i+1 is an integer greater than 1 and less than or equal to N; and
connecting load ends of the first-stage circulator to the N^{th}-stage circulator to respective power loads respectively.

Wherein, the M-port circulator is a dual-port circulator.

The circulator power amplifier circuit designed by the above design method of the circulator power amplifier circuit enhances the isolation of the circulator, and it is of great significance in terms of improving a standing wave of the power amplifier, of ensuring the stability of specification, of preventing mismatch damages of the power amplifier, and of increasing reliability of the power amplifier.

### Brief Description of Drawings

Fig. 1 is a structural diagram of a general single-circulator power amplifier circuit;
Fig. 2 is a structural diagram of a dual-circulator power amplifier circuit according to embodiment one of the present invention;
Fig. 3 is a structural diagram of a dual-circulator power amplifier circuit according to embodiment two of the present invention; and
Fig. 4 is a structural diagram of a two-port circulator according to an embodiment of the present invention.

### Preferred Embodiments of the Present Invention

In order to make the purpose, technical schemes and advantages of the present invention more clear and apparent, the embodiments of the present invention will be illustrated in detail hereinafter in conjunction with accompanying drawings. It should be illustrated that, in the case of no conflict, the embodiments of this application and the features in the embodiments could be combined randomly with each other. These combinations are within the protection scope of the present invention.

The embodiments of the present invention provide a circulator power amplifier circuit, comprising a power amplifier, a circulator, a power load and a load, and an output end of the power amplifier is connected to an input end of the circulator, and the load is connected to an output end of the circulator, and the power load is connected to the load end of the circulator, wherein, the circulator is an N-stage circulator or an M-port circulator, where both N and M are integers greater than one.

When the circulator is an N-stage circulator, an input end of a first-stage circulator is connected to the power amplifier, and an output end of an N^{th}-stage circulator is connected to the load and an output end of an i^{th}-stage circulator is connected to an input end of an i+1^{th}-stage circulator, and after load ends of the first-stage circulator to the N^{th}-stage circulator are connected, the load ends are connected to the power load, or the load ends of the first-stage circulator to the N^{th}-stage circulator are respectively connected to respective power loads, wherein, i+1 is an integer greater than 1 and less than or equal to N.

As shown in Fig. 2, a structural diagram of a dual-circulator power amplifier circuit according to embodiment one of the present invention is illustrated. In the circuit, the power amplifier is connected to a two-stage circulator (i.e., a dual-circulator) at the output end and the two-stage circulator is followed by the load. Wherein, an input end of a first-stage circulator in the two-stage circulator is connected to the power amplifier, an output end of a second-stage circulator is connected to the load, an output end of the first-stage circulator is connected to an input end of the second-stage circulator, and after the load ends of the first-stage and second-stage circulators are connected, the load ends are connected to the power load.

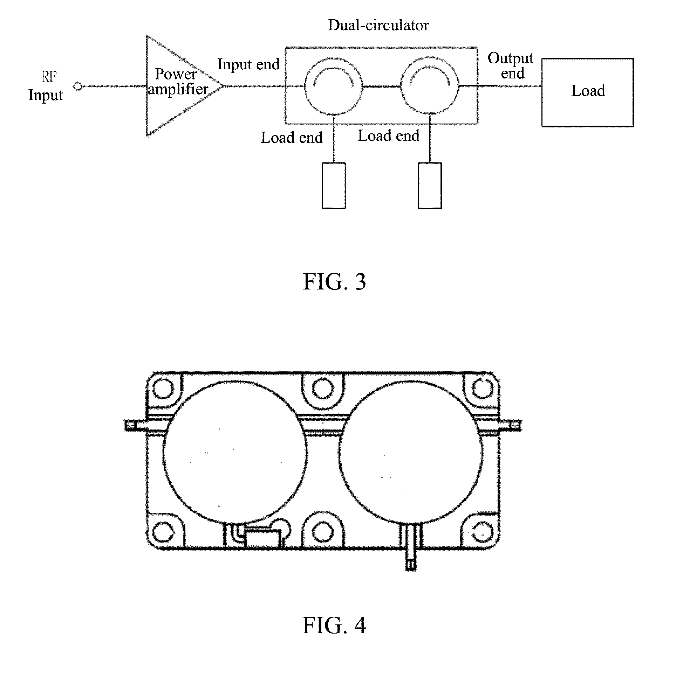

Of course, the structure of the dual-stage circulator in Fig. 2 may also be changed. For example, the load ends of the first-stage and second-stage circulators are connected respectively to respective power loads, as shown in Fig. 3.

The circuit adopts a dual-circulator to enable the isolation between the output end of the power amplifier and the load (such as an antenna) to be increased to about 46dB, thus weakening the influence of the output end of the power amplifier due to the sensitivity of the load and ensuring the stability of specification. Secondly, compared with the single-circulator structure, the standing wave of the dual-circulator structure is also improved. In addition, high isolation can also prevent mismatch damages of the power amplifier, and the reliability is largely enhanced. Further, it is easy for implementation. One-stage or multi-stage circulator is added on basis of the normal single-circulator structure, and when the multi-stage circulator structure is used, the volume and cost should be considered, and a circulator device with a low insertion loss should be selected, for example, an N-stage circulator with an insertion loss value within 0.4-0.6dB can be selected.

In addition, the above circulator can also be a dual-port circulator with high isolation from some manufacturers. The structure of the dual-port circulator is shown in Fig. 4, and the insertion loss value of the dual-port circulator is within 0.2-0.3dB.

In conclusion, the above circulator power amplifier circuit has advantages such as a simple structure, easy implementation, high isolation, a good improvement condition of the standing wave, a strong ability of preventing mismatch damages of the power amplifier and high reliability, and it is especially suitable to be applied to a radio frequency power amplifier circuit with a large transmission power.

The embodiments of the present invention further provide a design method for a circulator power amplifier circuit, comprising:
step 11: connecting an output end of a power amplifier to an input end of a multi-circulator;
step 12: connecting an output end of the multi-circulator to a load; and
step 13: connecting a load end of the multi-circulator to a power load,
wherein, the multi-circulator is an N-stage circulator or an M-port circulator, wherein, both N and M are integers greater than one.

Wherein, when the circulator is an N-stage circulator, the method may specifically comprise:
connecting the output end of the power amplifier to an input end of a first-stage circulator; connecting an output end of an N^{th}-stage circulator to the load; connecting an output end of an i^{th}-stage circulator to an input end of an i+1^{th}-stage circulator; and after load ends of the first-stage circulator to the N^{th}-stage circulator are connected, connecting the load ends to the power load; or
connecting the output end of the power amplifier to an input end of a first-stage circulator; connecting an output end of an N^{th}-stage circulator to the load; connecting an output end of an i^{th}-stage circulator to an input end of an i+1^{th}-stage circulator; and connecting load ends of the first-stage circulator to the N^{th}-stage circulator to respective power loads respectively, wherein, i+1 is an integer greater than 1 and less than or equal to N.

In addition, the M-port circulator is preferably a dual-port circulator with high isolation.

Rationality of a grooving size should further be noted in design, fixation of screws and good grounding should be noted in installation, and selection of suitable power loads according to power levels should be noted and so on.

The circulator power amplifier circuit designed by the above design method of the circulator power amplifier circuit has advantages such as high isolation, a good improvement condition of the standing wave, a strong ability of preventing mismatch damages of the power amplifier and high reliability, and it is especially suitable to be applied to a radio frequency power amplifier circuit with a large transmission power.

A person having ordinary skill in the art can understand that all or a part of steps in the above method can be implemented by programs instructing related hardware, which can be stored in a computer readable storage medium, such as a read-only memory, a disk or a CD etc. Alternatively, all or a part of steps in the above embodiments can also be implemented by one or more integrated circuits. Accordingly, each module/unit in the above embodiments can be implemented in the form of hardware, or can also be implemented in the form of software functional module. The present invention is not limited to any particular form of a combination of hardware and software.

The above embodiments are only used to illustrate technical solutions of the present invention without limitation, and the present invention is merely described in detail with reference to preferred embodiments. Those of ordinary skill in the art should understand that modifications or equivalent substitutions can be made on the technical solutions of the present invention without departing from the spirit and scope of the technical solutions of the present invention, all of which should be contained within the scope of the claims of the present invention.

### Industrial Applicability

The circulator power amplifier circuit designed by the above design method of the circulator power amplifier circuit enhances the isolation of the circulator, and it is of great significance in terms of improving a standing wave of the power amplifier, of ensuring stability of specification, of preventing mismatch damages of the power amplifier, and of increasing reliability of the power amplifier. Therefore, the present invention has a powerful industrial applicability.

## Claims

1. A circulator power amplifier circuit, comprising a power amplifier, a circulator, a power load and a load, an output end of the power amplifier connected to an input end of the circulator, the load connected to an output end of the circulator, the power load connected to a load end of the circulator, wherein,
the circulator is an N-stage circulator or an M-port circulator, where both N and M are integers greater than one.

2. The circulator power amplifier circuit according to claim 1, wherein,
when the circulator is the N-stage circulator, an input end of a first-stage circulator is connected to the power amplifier, and an output end of an N^{th}-stage circulator is connected to the load, and an output end of an i^{th}-stage circulator is connected to an input end of an i+1^{th}-stage circulator, and after load ends of the first-stage circulator to the N^{th}-stage circulator are connected, the load ends are connected to the power load, wherein, i+1 is an integer greater than 1 and less than or equal to N.

3. The circulator power amplifier circuit according to claim 1, wherein,
when the circulator is the N-stage circulator, an input end of a first-stage circulator is connected to the power amplifier, and an output end of an N^{th}-stage circulator is connected to the load, and an output end of an i^{th}-stage circulator is connected to an input end of an i+1^{th}-stage circulator, and load ends of the first-stage circulator to the N^{th}-stage circulator are respectively connected to respective power loads, wherein, i+1 is an integer greater than 1 and less than or equal to N.

4. The circulator power amplifier circuit according to any one of claims 1-3, wherein, an insertion loss value of the N-stage circulator is within 0.4-0.6dB.

5. The circulator power amplifier circuit according to claim 1, wherein,
the M-port circulator is a dual-port circulator.

6. The circulator power amplifier circuit according to claim 5, wherein,
an insertion loss value of the M-port circulator is within 0.2-0.3dB.

7. A connection method for a circulator power amplifier circuit, comprising:
connecting an output end of a power amplifier to an input end of a multi-circulator, connecting an output end of the multi-circulator to a load, and connecting a load end of the multi-circulator to a power load,
wherein, the multi-circulator is an N-stage circulator or an M-port circulator, wherein, both N and M are integers greater than one.

8. The connection method according to claim 7, wherein, when the circulator is the N-stage circulator, the step of connecting an output end of a power amplifier to an input end of a multi-circulator, connecting an output end of the multi-circulator to a load, and connecting a load end of the multi-circulator to a power load comprises:
connecting the output end of the power amplifier to an input end of a first-stage circulator;
connecting an output end of an N^{th}-stage circulator to the load;
connecting an output end of an i^{th}-stage circulator to an input end of an i+1^{th}-stage circulator, wherein, i+1 is an integer greater than 1 and less than or equal to N; and
after load ends of the first-stage circulator to the N^{th}-stage circulator are connected, connecting the load ends to the power load.

9. The connection method according to claim 7, wherein, when the circulator is the N-stage circulator, the step of connecting an output end of a power amplifier to an input end of a multi-circulator, connecting an output end of the multi-circulator to a load, and connecting a load end of the multi-circulator to a power load comprises:
connecting the output end of the power amplifier to an input end of a first-stage circulator;
connecting an output end of an N^{th}-stage circulator to the load;
connecting an output end of an i^{th}-stage circulator to an input end of an i+1^{th}-stage circulator, wherein, i+1 is an integer greater than 1 and less than or equal to N; and
connecting load ends of the first-stage circulator to the N^{th}-stage circulator to respective power loads respectively.

10. The connection method according to claim 7, wherein,
the M-port circulator is a dual-port circulator.
